# FASCICULE DE BREVET EUROPEEN

(11) **EP 1 113 503 B1**
(45) Date de publication et mention de la délivrance du brevet: **03.06.2009**
(21) Numéro de dépôt: 99126005.0
(22) Date de dépôt: 27.12.1999
(51) Int. Cl.: H01L 31/0216, G04C 10/02

(54) **Procédé de fabrication d'une cellule photovoltaique colorée, notamment pour cadran de montre**
Verfahren zur Herstellung einer Farbigen photovoltaischen Zelle, insbesondere für das Ziffernblatt einer Uhr
Manufacturing method for a colored photovoltaic cell, in particular for watch face

(43) Date de publication de la demande: 04.07.2001
(73) Titulaire: ASULAB S.A., CH-2501 Bienne (CH)
(72) Inventeur: Saurer, Eric, 2022 Bevaix (CH); Viennet, René, 2000 Neuchâtel (CH); Ziegler, Yvan, 2057 Villiers (CH); Fischer, Diego, 2000 Neuchâtel (CH)
(74) Mandataire: Rossand, Isabelle

(56) Documents cités:
- US-A- 5 782 995

## Description

La présente invention concerne un procédé de fabrication d'une cellule photovoltaïque, dite aussi cellule solaire, utilisable pour former un cadran d'une montre ou d'un autre appareil électronique et fournir de l'énergie électrique à la montre ou à cet appareil.

L'invention concerne plus particulièrement un procédé de fabrication d'une cellule photovoltaïque colorée du genre comportant de bas en haut un substrat, une électrode inférieure réfléchissante placée sur le substrat ou intégrée à celui-ci, une partie active de photodiode formée de couches de semi-conducteur et une électrode supérieure.

L'utilisation de cellules photovoltaïques comme cadrans de montres-bracelets rencontre divers problèmes qui peuvent être d'ordre technique ou esthétique. Premièrement, lorsque la montre est portée, la cellule ou un ensemble de cellules branchées en série doit assurer une production d'énergie suffisante non seulement à court terme, mais aussi dans le cadre du bilan énergétique annuel de l'élément de stockage (accumulateur), pour tenir compte des périodes de faible éclairement, en particulier l'hiver. Comme la superficie d'un cadran de montre est restreinte, la cellule doit avoir un rendement de conversion suffisant. En outre on souhaite avoir une cellule aussi mince que possible. Les cellules photovoltaïques en silicium amorphe sont avantageuses à cet égard, particulièrement si le substrat est de nature métallique et constitue l'une des électrodes collectrices de courant.

D'autre part, les critères esthétiques sont importants dans le domaine de horlogerie. Ils conduisent à préférer l'utilisation d'une seule cellule au lieu de plusieurs cellules juxtaposées et connectées en série, afin d'éviter les lignes de séparation et d'interconnexion qui restent visibles entre les cellules. Un critère esthétique primordial est celui de la couleur. Les cellules en silicium amorphe déposé sur un substrat métallique ont par elles-mêmes un aspect grisâtre qui est peu plaisant. On mentionnera ci-dessous diverses publications proposant des solutions pour éviter cet inconvénient. Enfin, en plus de l'obtention de couleurs plaisantes, variées et suffisamment lumineuses, on peut désirer que le cadran donne soit une réflexion spéculaire, soit une réflexion diffuse.

Dans la demande de brevet EP 872 783, il est décrit un cadran de montre formé d'une seule cellule photovoltaïque au silicium amorphe hydrogéné (α-Si:H), dont l'électrode supérieure est formée d'une couche métallique transflective, c'est-à-dire semi-réfléchissante, qui réfléchit de préférence entre 60% et 85% de la lumière incidente. Ceci permet une construction simple et mince, donnant au cadran un éclat métallique, mais le rendement de conversion est réduit par le fait que la majorité de la lumière incidente est réfléchie vers l'extérieur ou absorbée dans la couche métallique et n'atteint donc pas le silicium.

Une autre catégorie de solutions connues, notamment par les publications EP 788 037 et EP 819 995, consiste à placer sur la cellule photovoltaïque une plaque formée de diverses couches translucides colorées donnant par elles-mêmes l'aspect voulu du cadran. Toutefois ces plaques doivent être diffusantes pour masquer le silicium, ce qui d'une part réduit la quantité de lumière atteignant la photodiode et d'autre part donne au cadran un aspect laiteux, dépourvu d'éclat. En outre cette plaque augmente l'épaisseur totale de la construction.

La présente invention a pour but de créer une cellule photovoltaïque permettant d'éviter les inconvénients susmentionnés lorsqu'elle est utilisée comme cadran d'une montre ou d'un appareil imposant les mêmes critères esthétiques. En particulier, l'invention devrait permettre un large choix de couleurs du cadran, sans réduire excessivement la portion de la lumière incidente qui parvient à la photodiode. Un but additionnel est d'offrir au constructeur le choix entre un reflet spéculaire et un reflet diffus de la lumière incidente.

Selon un premier aspect de l'invention, il est prévu un procédé de fabrication d'une cellule photovoltaïque du genre indiqué plus haut, ce procédé étant **caractérisé en ce que** le couple des épaisseurs respectives de l'électrode supérieure et de la partie active de photodiode est sélectionné en fonction des indices de réfraction respectifs de leurs matériaux de façon à produire une réflexion interférentielle de la lumière incidente selon un spectre de réflexion prédéterminé.

Ainsi, la structure multicouches de la cellule photovoltaïque constitue un filtre interférentiel réflectif avec lequel il est possible d'obtenir une large gamme de couleurs de la lumière réfléchie, simplement par un choix approprié des épaisseurs des couches produisant la réflexion interférentielle, en utilisant les matériaux constitutifs de la cellule photovoltaïque. En pratique, on sélectionne lesdites épaisseurs dans les gammes d'épaisseurs compatibles avec un bon fonctionnement de la cellule photovoltaïque, en particulier du point de vue de la puissance qu'elle fournit.

Les parties du spectre dans lesquelles une fraction substantielle de la lumière incidente est réfléchie vers l'extérieur peuvent être relativement étroites, de sorte que la plus grande part de la lumière ambiante incidente est absorbée par la photodiode pour y produire de l'énergie électrique. Ce type de cellule permet ainsi d'obtenir, toutes conditions étant égales, des courants largement supérieurs à ceux d'une cellule à électrode supérieure métallique semi-réfléchissante et recouverte de laque colorée. La photodiode peut avantageusement être réalisée de manière classique en silicium amorphe hydrogéné. De préférence, le substrat est métallique et sert à la fois d'électrode inférieure et de réflecteur.

De préférence, la partie active de photodiode en silicium a une épaisseur comprise entre 100 et 600 nm et l'électrode supérieure a une épaisseur comprise entre 60 et 300 nm, les combinaisons deux à deux de ces épaisseurs conduisant à une couleur déterminée de la lumière réfléchie. Dans des gammes d'épaisseurs particulièrement préférées, la partie active de photodiode en silicium a une épaisseur comprise entre 250 et 450 nm et l'électrode supérieure a une épaisseur comprise entre 70 et 150 nm. Au-dessous de ces limites inférieures, la résistance par carré de l'électrode supérieure augmente, en créant des pertes ohmiques indésirables, et la conversion d'énergie dans le silicium est réduite si l'épaisseur de silicium est trop faible. Au-dessus des limites supérieures mentionnées, la déposition de l'électrode supérieure devient trop coûteuse et la tenue mécanique du silicium sur le substrat devient problématique.

Pour élargir encore la palette des couleurs disponibles, un développement de l'invention consiste en que l'électrode supérieure est recouverte d'une couche de laque transparente, qui peut être aussi diffusante. Cette couche peut en outre contenir des colorants ou pigments, présentant ainsi un spectre d'absorption prédéterminé afin de moduler la couleur de la lumière réfléchie par absorption de certaines longueurs d'onde. Ces techniques permettent d'obtenir des cadrans simulant l'aspect et les couleurs de cadrans de montres traditionnels.

D'autres caractéristiques et avantages de l'invention apparaîtront dans la description suivante de divers modes de réalisation, présentés à titre d'exemples non limitatifs en référence aux dessins annexés, dans lesquels :
la figure 1 est une vue schématique en coupe partielle d'un premier mode de réalisation d'une cellule photovoltaïque selon l'invention, formant un cadran de montre,
la figure 2 est une vue analogue à la figure 1, représentant un deuxième mode de réalisation de l'invention,
la figure 3 est une vue analogue à la figure 1, représentant un troisième mode de réalisation de l'invention,
la figure 4 représente la réflectance en fonction de la longueur d'onde, obtenue avec la structure illustrée par la figure 1 pour différents couples d'épaisseurs du silicium et de l'électrode supérieure transparente,
la figure 5 représente les coordonnées RGB de la lumière réfléchie pour les structures dont le spectre de réflexion est représenté à la figure 4,
la figure 6 représente la réflectance en fonction de la longueur d'onde, obtenue avec les structures illustrées respectivement par les figures 1, 2 et 3, pour un couple sélectionné des épaisseurs respectives du silicium et de l'électrode supérieure transparente, et
la figure 7 représente le spectre d'absorption d'un colorant utilisé dans l'un des cas représentés aux figures 3 et 6 (courbe 26).

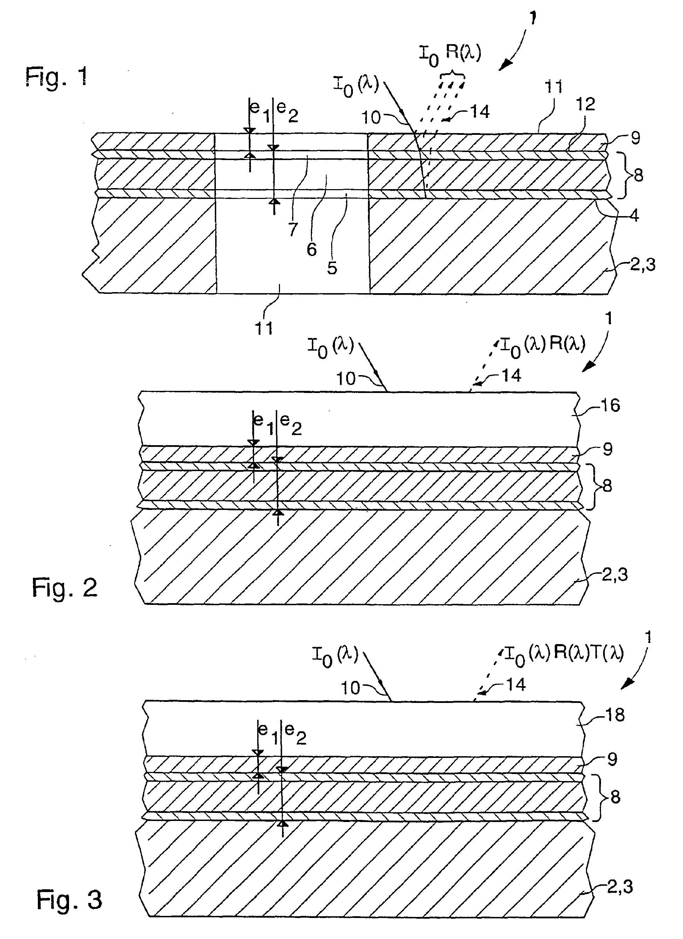

Le cadran de montre représenté à la figure 1 est formé par une cellule photovoltaïque 1 selon la présente invention, comportant un substrat métallique 2 qui sert d'électrode inférieure 3 de la cellule. Le substrat 2 est de préférence en acier inoxydable, mais d'autres métaux tels que l'aluminium ou un substrat métallique recouvert de chrome peuvent être utilisés. La surface supérieure 4 du substrat réfléchit la lumière, soit de façon spéculaire, soit de façon diffuse, afin d'améliorer le rendement énergétique. Le substrat 2 supporte un empilement de trois couches minces 5, 6 et 7 de silicium amorphe hydrogéné, respectivement de types n, i et p ou inversement, pour former la partie active d'une photodiode à jonction n-i-p ou p-i-n, indiquée par la référence 8. Sur l'empilement des couches de silicium est appliquée une électrode supérieure transparente 9 formée d'une couche mince d'oxyde conducteur, par exemple une couche d'oxyde d'indium dopée à l'étain (ITO), ou une couche d'oxyde d'étain dopée à l'antimoine.

Dans la montre, le raccordement des électrodes au circuit de charge de l'accumulateur électrique s'effectue de manière classique sur un bord du cadran formé par la cellule 1. Un trou central 11 est ménagé à travers le cadran, pour laisser passer les arbres des aiguilles de la montre.

Bien entendu, l'électrode inférieure 3 pourrait comporter une couche métallique réfléchissante faite d'un matériau distinct du substrat 2, au cas où le matériau du substrat ne serait pas compatible avec la couche adjacente 5 de type n ou p.

Les couches de silicium et d'ITO peuvent être déposées par des procédés classiques permettant une bonne maîtrise de l'épaisseur des couches, par exemple le dépôt en plasma RF pour le silicium et le dépôt par pulvérisation cathodique pour l'ITO. Des exemples de procédés de fabrication en lots de cellules photovoltaïques de ce genre sont exposés en particulier dans les brevets US 4 485 125, US 5 457 057 et EP 948 060.

Les couches de silicium formant la partie active de photodiode 8 ont une épaisseur totale contrôlée e₂ et un indice de réfraction ayant une partie réelle d'environ 4. L'ITO formant l'électrode supérieure 9 a une épaisseur contrôlée e₁ et un indice de réfraction réel d'environ 2, l'absorption pouvant être négligée dans le cas particulier d'une telle couche. En conséquence, les deux couches 8 et 9 constitutives de la cellule photovoltaïque, disposées entre l'air et le substrat métallique, forment un système optique interférentiel présentant une réflectance R(λ), où λ est la longueur d'onde de la lumière incidente 10, laquelle a une intensité spectrale I₀(λ). La lumière 14 réfléchie par la cellule 1, d'intensité spectrale I₀(λ) R(λ), présente un aspect coloré dépendant de la réflectance R(λ) définie par les indices et épaisseurs des éléments du système interférentiel.

Connaissant les indices de réfraction des matériaux utilisés pour réaliser la cellule photovoltaïque, on peut calculer le spectre de réflexion interférentiel et les indices chromatiques correspondants en fonction des épaisseurs e₁ et e₂ et sélectionner les combinaisons d'épaisseurs fournissant les couleurs souhaitées, en tenant compte des contraintes imposées pour obtenir de bonnes caractéristiques électriques et mécaniques de la cellule photoélectrique. Les mêmes opérations peuvent être faites avec d'autres matériaux, ayant d'autre indices de réfraction.

La figure 2 représente un deuxième mode de réalisation dans lequel la structure de la cellule photovoltaïque 1 décrite en référence à la figure 1 est complétée par une couche de laque 16 transparente ou diffusante, appliquée sur l'électrode supérieure 9. Cette couche, ayant un indice de réfraction d'environ 1,5 et une épaisseur de l'ordre de 1 µm à quelques dizaines de µm, modifie la réflectance R(λ) du système interférentiel sous-jacent, du fait de son indice de réfraction différent de celui de l'ITO. De plus, une laque diffusante reproduit mieux l'aspect des cadrans traditionnels, en réduisant ou éliminant la dépendance angulaire des interférences dans la lumière réfléchie. Dans cet exemple, la laque de la couche 16 n'a pas d'absorption intrinsèque, c'est-à-dire pas de couleur propre. Comme son épaisseur est relativement grande, sa seule influence notable dans la réflexion interférentielle est celle de son indice de réfraction modifiant les conditions optiques à l'interface entre la laque et l'électrode supérieure 9. D'autre part la laque constitue une protection mécanique et chimique de l'électrode 9.

La figure 3 représente un troisième mode de réalisation dans lequel la structure de la cellule photovoltaïque 1 décrite en référence à la figure 1 est complétée par une couche de laque colorée 18 , transparente ou légèrement diffusante, appliquée sur l'électrode supérieure 9. En plus de produire les mêmes effets que la couche de laque incolore 16, la laque colorée 18 présente un spectre de transmission T(λ) qui modifie la lumière réfléchie 14 dont le spectre est obtenu par convolution des spectres I₀(λ), R(λ) et T(λ). Par ce moyen, il est possible de modifier la couleur de la lumière réfléchie, par exemple afin d'éliminer certaines composantes indésirables du spectre de réflexion interférentiel. Ceci permet d'obtenir un grand nombre de nuances de couleurs en utilisant les principes de la présente invention.

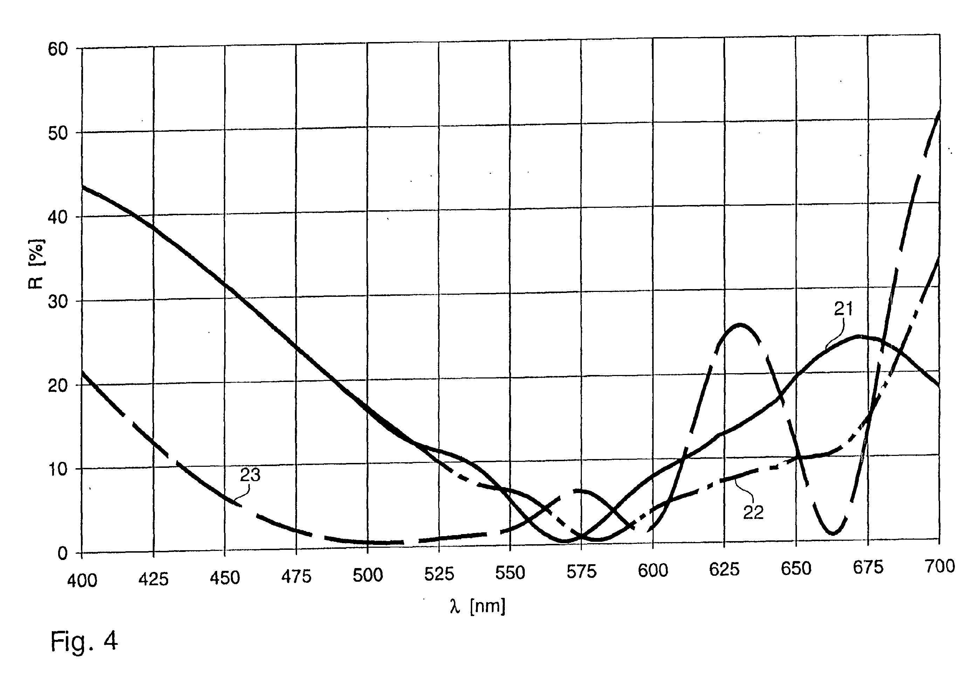

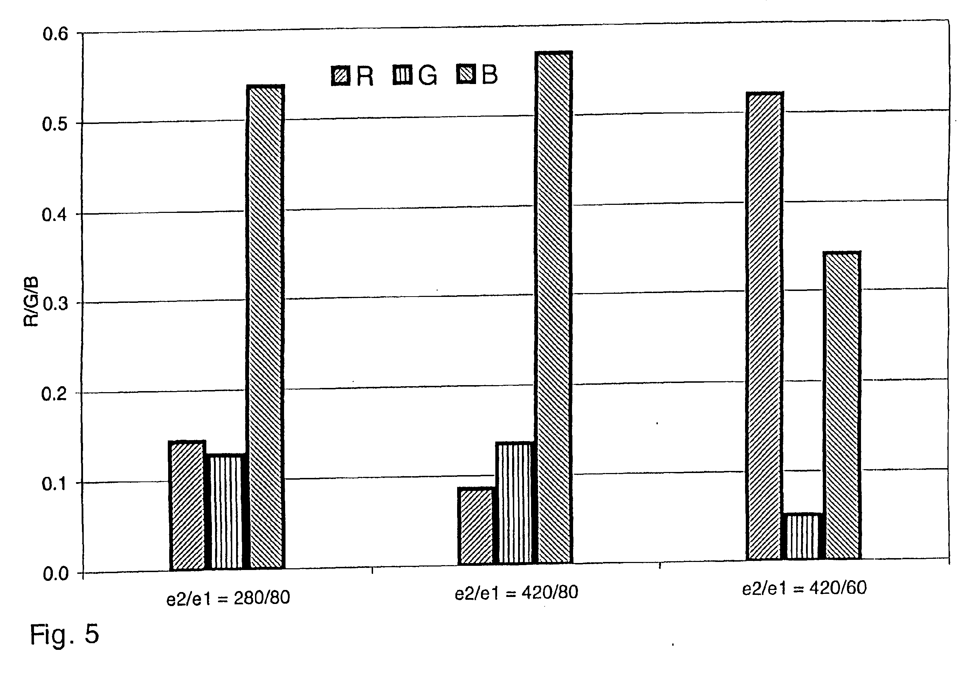

La figure 4 est une représentation spectrale de la réflectance R en fonction de la longueur d'onde λ pour trois exemples de cellules photovoltaïques ayant la structure illustrée par la figure 1, pour trois différents couples des épaisseurs e₁ et e₂. La figure 5 montre les coordonnées de couleurs R (rouge), G (vert) et B (bleu) pour ces trois exemples.

Le spectre 21, dessiné en trait continu, correspond à des épaisseurs e₂ = 280 nm de silicium et e₁ = 80 nm d'ITO. Selon la figure 5, la lumière réfléchie aura une couleur dominante bleue.

Le spectre 22, dessiné en trait mixte, correspond à la même valeur e₁ = 80 nm que dans l'exemple précédent, mais avec une valeur e₂ = 420 nm pour l'épaisseur de silicium. On voit que le spectre est ainsi modifié dans la région du vert et du rouge et que la lumière réfléchie aura aussi une couleur dominante bleue mais légèrement différente.

Le spectre 23, dessiné en trait interrompu, correspond à la même valeur e₂ = 420 nm que dans l'exemple précédent, mais avec une valeur e₁ = 60 nm au lieu de 80 nm pour l'épaisseur d'ITO. On voit que le spectre est ainsi fortement modifié dans plusieurs régions et que la lumière réfléchie aura une couleur dominante magenta. On en déduit que l'épaisseur de l'électrode en ITO a une importance prépondérante dans les exemples considérés.

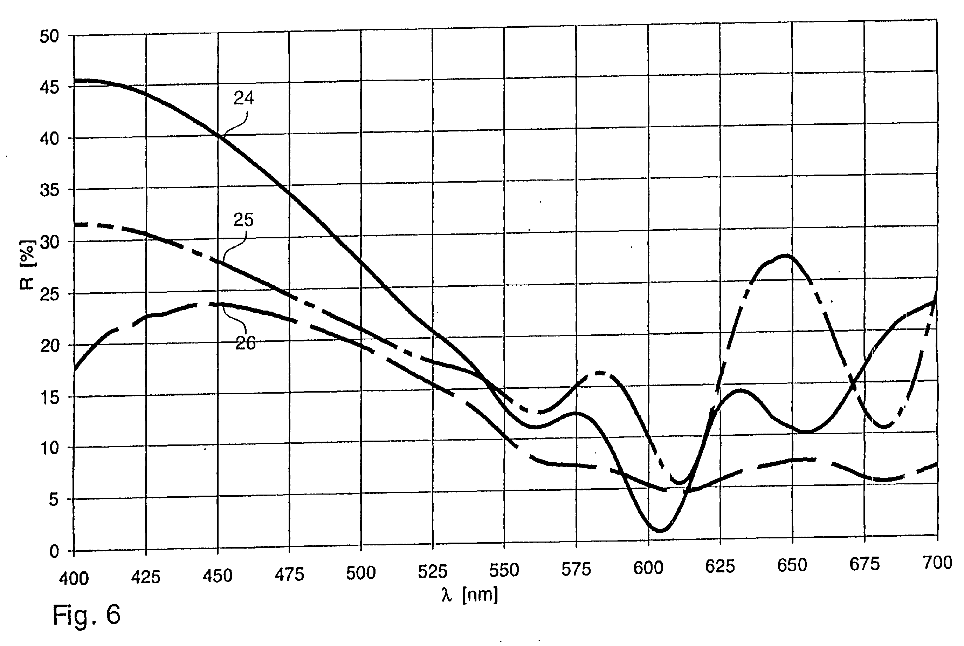

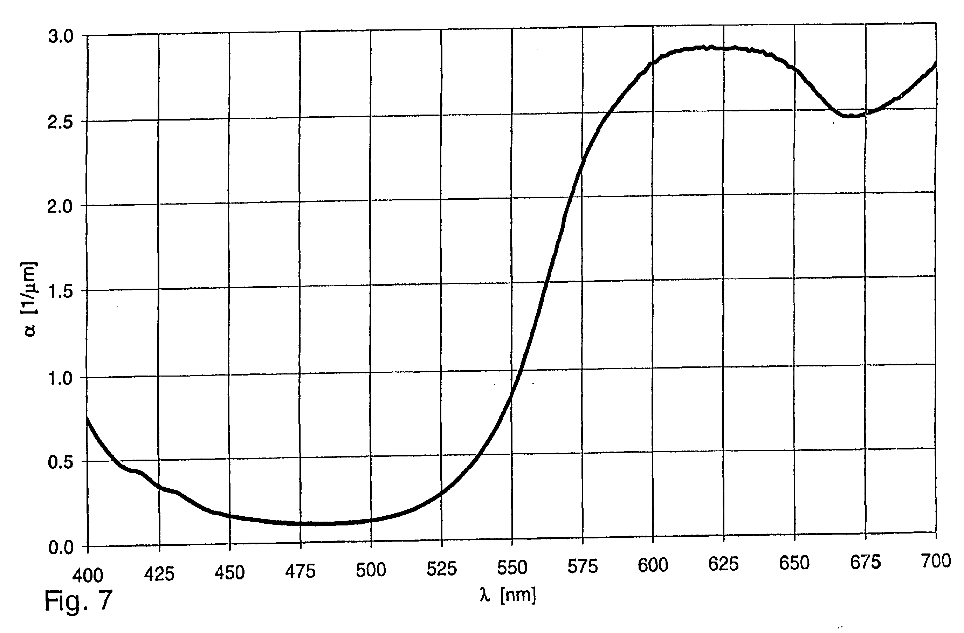

La figure 6 est une représentation spectrale de la réflectance R en fonction de la longueur d'onde λ pour trois exemples de cellules photovoltaïques ayant les structures illustrées respectivement par les figures 1, 2 et 3, pour un même couple de valeurs e₂ = 450 nm et e₁ = 90 nm des épaisseurs respectives de silicium et d'ITO. Le spectre 24, dessiné en trait continu, correspond à la version sans laque de la figure 1 et présente une forte dominante dans le bleu. Le spectre 25, dessiné en trait mixte, correspond à la version de la figure 2, avec une couche de laque incolore 16 d'indice 1,5 ayant une épaisseur de plusieurs µm. Par rapport au spectre 24, il est fortement réduit dans le bleu et plus marqué dans le vert et le rouge. Le spectre 26, dessiné en trait interrompu, correspond à la version de la figure 3, avec une couche de laque 18 mélangée à un colorant bleu dont le spectre d'absorption α(λ) est représenté à la figure 7, cette couche ayant une épaisseur de quelques µm. On voit que l'adjonction de colorant réduit la quantité de lumière réfléchie, surtout dans le jaune et le rouge.

Les exemples donnés ci-dessus montrent que la présente invention fournit à un homme du métier des moyens pour concevoir des cellules photovoltaïques ayant une structure la plus simple possible et un rendement suffisant, tout en présentant une couleur prédéterminée, de sorte qu'elles sont bien adaptées pour servir de cadrans de montres ou d'autres appareils portables dont l'esthétique est un paramètre important.

## Revendications

1. Procédé de fabrication d'une cellule photovoltaïque colorée comportant de bas en haut un substrat (2), une électrode inférieure réfléchissante (3) placée sur le substrat ou intégrée à celui-ci, une partie active de photodiode (8) formée de couches de semi-conducteur et une électrode supérieure transparente (9),
ce procédé étant **caractérisé en ce qu'**il comprend l'étape consistant à sélectionner le couple des épaisseurs respectives (e₁, e₂) de l'électrode supérieure (9) et de la partie active de photodiode (8) en fonction des indices de réfraction respectifs de leurs matériaux de façon à produire une réflexion interférentielle de la lumière incidente selon un spectre de réflexion prédéterminé.

2. Procédé selon la revendication 1, **caractérisé en ce que** ledit semi-conducteur est du silicium amorphe hydrogéné de types n, i et p.

3. Procédé selon la revendication 1 ou 2, **caractérisé en ce que** l'électrode supérieure (9) est recouverte d'une couche de laque transparente (16, 18).

4. Procédé selon la revendication 3, **caractérisé en ce que** ladite couche de laque (16, 18) est diffusante.

5. Procédé selon la revendication 3 ou 4, **caractérisé en ce que** ladite couche de laque (18) contient des colorants ou des pigments.

6. Procédé selon l'une des revendications précédentes, **caractérisé en ce que** le substrat (2) est métallique et sert à la fois d'électrode inférieure (3) et de réflecteur.

7. Procédé selon la revendication 2, **caractérisé en ce que** la partie active de photodiode (8) en silicium a une épaisseur (e₂) comprise entre 100 et 600 nm et l'électrode supérieure (9) a une épaisseur (e₁) comprise entre 60 et 300 nm, les combinaisons deux à deux de ces épaisseurs conduisant à une couleur déterminée de la lumière réfléchie (14).

8. Procédé selon la revendication 7, **caractérisée en ce que** la partie active de photodiode (8) en silicium a une épaisseur (e₂) comprise entre 250 et 450 nm et l'électrode supérieure (9) a une épaisseur (e₁) comprise entre 70 et 150 nm.

## Claims

1. Method of manufacturing a coloured photovoltaic cell including from the bottom to the top a substrate (2), a reflective bottom electrode (3) placed on the substrate or integrated therein, an active photodiode part (8) formed of semiconductor layers, and a transparent top electrode (9),
this method being **characterised in that** if comprises the step of selecting the pair of respective thicknesses (e₁, e₂) of the top electrode (9) and the active photodiode part (8) is selected as a function of the respective refractive indices of their materials, so as to produce an interferential reflection of the incident light according to a predetermined reflection spectrum.

2. Method according to claim 1, **characterised in that** said semiconductor is hydrogenated amorphous silicon of types n, i and p.

3. Method according to claims 1 or 2, **characterised in that** the top electrode (9) is coated with a layer of clear lacquer (16, 18).

4. Method according to claim 3, **characterised in that** said layer of lacquer (16, 18) is diffusing.

5. Method according to claims 3 or 4, **characterised in that** said layer of lacquer (18) contains colorants or pigments.

6. Method according to any of the preceding claims, **characterised in that** the substrate (2) is metal and serves both as the bottom electrode (3) and as a reflector.

7. Method according to claim 2, **characterised in that** the active photodiode part (8) made of silicon has a thickness (e₂) comprised between 100 and 600 nm and the top electrode (9) has a thickness (e₁) comprised between 60 and 300 nm, the pairing of said thicknesses leading to a determined colour of the reflected light (14).

8. Method according to claim 7, **characterised in that** the active photodiode part (8) made of silicon has a thickness (e₂) comprised between 250 and 450 nm and the top electrode (9) has a thickness (e₁) comprised between 70 and 150 nm.

## Patentansprüche

1. Verfahren zum Herstellen einer farbigen Solarzelle, welche von oben nach unten ein Substrat (2), eine untere reflektierende Elektrode (3), die auf dem Substrat angeordnet oder in dieses integriert ist, einen aktiven Fotodiodenbereich (8), der aus Halbleiterschichten gebildet ist, und eine durchsichtige obere Elektrode (9) umfasst ,
wobei dieses Verfahren **dadurch gekennzeichnet ist, dass** es einen Schritt umfasst, der darin besteht, das Paar jeweiliger Dicken (e₁, e₂) der oberen Elektrode (9) und des aktiven Fotodiodenbereichs (8) in Abhängigkeit von den jeweiligen Brechungsindizes von deren Materialien derart auszuwählen, dass eine Interferenzreflexion des einfallendes Lichtes gemäss einem bestimmten Reflexionsspektrum erzeugt wird.

2. Verfahren nach Anspruch 1, **dadurch gekennzeichnet, dass** der Halbleiter amorphes hydrogenisiertes Silizium vom Typ n, i oder p ist.

3. Verfahren nach Anspruch 1 oder 2, **dadurch gekennzeichnet, dass** die obere Elektrode mit einer durchsichtigen Lackschicht (16, 18) bedeckt ist.

4. Verfahren nach Anspruch 3, **dadurch gekennzeichnet, dass** die Lackschicht (16, 18) streuend ist.

5. Verfahren nach Anspruch 3 oder 4, **dadurch gekennzeichnet, dass** die Lackschicht (18) Farbstoffe oder Pigmente enthält.

6. Verfahren nach einem der vorstehenden Ansprüche, **dadurch gekennzeichnet, dass** das Substrat (2) metallisch ist, und gleichzeitig als untere Elektrode (3) und als Reflektor dient.

7. Verfahren nach Anspruch 2, **dadurch gekennzeichnet, dass** der aktive Fotodiodenbereich (8) aus Silizium eine Dicke (e₂) zwischen 100 und 600 nm und die obere Elektrode (9) eine Dicke (e₁) zwischen 60 und 300 nm besitzt, wobei die Kombination dieser beiden Dicken miteinander zu einer bestimmten Farbe des reflektierten Lichtes (14) führt.

8. Verfahren nach Anspruch 7, **dadurch gekennzeichnet, dass** der aktive Fotodiodenbereich (8) aus Silizium eine Dicke (e₂) zwischen 250 und 450 nm und die obere Elektrode (9) eine Dicke (e₁) zwischen 70 und 150 nm besitzt.
